(19) Europäisches Patentamt
European Patent Office
Office européen des brevets

(11) **EP 0 512 621 B1**

(12) # EUROPEAN PATENT SPECIFICATION

(45) Date of publication and mention
of the grant of the patent:
**13.08.1997 Bulletin 1997/33**

(51) Int Cl.6: **H03L 7/16**, H03L 7/081

(21) Application number: **92201212.5**

(22) Date of filing: **04.05.1992**

(54) **Digital phase locked loop, and digital oscillator arranged to be used in the digital phase locked loop**

Digitale Phasenverriegelungsschleife und digitaler Oszillator zum Gebrauch in der digitalen Phasenverriegelungsschleife

Boucle numérique à verrouillage de phase et oscillateur numérique conçu pour être utilisé dans la boucle numérique à verrouillage de phase

(84) Designated Contracting States:
**DE FR GB IT SE**

(30) Priority: **08.05.1991 EP 91201105**

(43) Date of publication of application:
**11.11.1992 Bulletin 1992/46**

(73) Proprietor: **Philips Electronics N.V.
5621 BA Eindhoven (NL)**

(72) Inventor: **Dijkhof, Antonie
NL-5656 AA Eindhoven (NL)**

(74) Representative:
**Deguelle, Wilhelmus Hendrikus Gerardus et al
INTERNATIONAAL OCTROOIBUREAU B.V.,
Prof. Holstlaan 6
5656 AA Eindhoven (NL)**

(56) References cited:
EP-A- 0 360 349          GB-A- 2 073 515
US-A- 2 881 320          US-A- 3 641 442
US-A- 4 468 788

- ELECTRONICS LETTERS vol. 11, no. 22, 30
October 1975, STEVENAGE ,GB pages 540 - 541
J. D. H. ALEXANDER 'LOGICAL
PHASE-CONTROLLED OSCILLATOR'

## Description

The invention relates to a digital Phase Locked Loop, comprising a Voltage Controlled Oscillator and a phase detector whose output is coupled to an input of the Voltage Controlled Oscillator *via* a low-pass filter, an output of the Voltage Controlled Oscillator being coupled to a first input of the phase detector whose second input is coupled to an output of a digital oscillator comprising shifting-cum-multiplexing means for shifting by a predetermined phase magnitude per time interval a reference signal presented to an input of the digital oscillator, and for generating an output signal at the output of the digital oscillator which output signal is the reference signal shifted by a predetermined phase magnitude per time interval. The invention further relates to a digital Phase Locked Loop using such oscillator loop.

A digital oscillator for such Phase Locked Loop is known from United States patent No. 4,468,788.

A simple digital oscillator may comprise programmable pulse generator generates a signal in the form of a plurality of pulses per time unit, for example, 2 million pulses per second. The frequency of this signal is then 2 MHz and may be reduced in a simple manner by blocking one or more pulses per time unit.

When a digital oscillator of this type is used in a Phase Locked Loop (PLL), the signal of the digital oscillator is fed to the phase detector together with the output signal of the Voltage Controlled Oscillator (VCO). *Via* the low-pass filter the phase detector output signal which is decisive for the phase difference between the two fed signals is presented to the input of the VCO. The time constant of the low-pass filter determines the time required by the PLL for reacting to the frequency changes of the signal of the digital oscillator and is therefore made smallest possible. The lower limit of the time constant is determined by the minimum frequency change of the signal of the digital oscillator. In some digital telephone exchanges a smallest possible frequency change of 1/64 Hz is demanded for a base frequency of 2 MHz with an accuracy of 100 ppm (200 Hz), which change corresponds to a variation of 1/64 pulse per second or a variation of 1 pulse per 64 seconds. The minimum required time constant is in this case 64 seconds, due to which the PLL then exhibits much too slow a reaction to frequency changes.

In the digital oscillator according to the above mentioned US patent comprises shifting-cum-multiplexing means which introduces phase shifts at regular instants into the reference signal. If the reference signal is shifted by a specific phase magnitude in a positive phase direction per time interval, the output signal has a lower frequency than the reference signal. If, on the other hand, the reference signal is shifted by a specific phase magnitude in a negative phase direction per time interval, the output signal has a higher frequency than the reference signal. If the frequency of the reference signal is, for example, 2 MHz and this signal is shifted by 90° in a positive phase direction every microsecond, there is a positive phase shift of 360° every 4 microseconds, which corresponds to a negative frequency change of 250 kHz. In this case the frequency of the output signal is 1.75 MHz. However, if the reference signal is shifted by 90° in a negative phase direction every microsecond, there will be a negative phase shift of 360° every 4 microseconds, which corresponds to a positive frequency change of 250 kHz. In that case the frequency of the output signal is 2.25 MHz.

Because a frequency change is not obtained by blocking one or more pulses per time unit, as occurs with a digital oscillator arranged as a programmable pulse generator, but because a frequency change is realised by this digital oscillator by causing a phase shift to occur every time interval, the output signal of the digital oscillator obtains a more uniform character. When the digital oscillator is used in the PLL, a low-pass filter with a smaller time constant may suffice, the degree of time constant reduction then depending on the extent of the phase shift. If this shift is, for example, 90°, it will be sufficient to have a 4 times smaller time constant.

It is an object of the invention to provide a digital PLL in which a low-pass filter having an even smaller time constant will suffice.

For this purpose the digital PLL is characterized in that the shifting-cum-multiplexing means of the digital oscillator are arranged for additionally phase-shifting the reference signal in the time interval by means of at least one phase pulse having a predetermined amplitude and situated in the time interval.

According to the invention the phase shift by the predetermined phase magnitude effected once per time interval is preceded by a phase pulse having a predetermined amplitude. The output signal of the oscillator is then better integrable due to a higher jitter frequency, so that it will be sufficient for the PLL to comprise a low-pass filter having an even smaller time constant.

In a first embodiment of the digital PLL according to the invention the digital PLL is characterized, in that the predetermined amplitude of the phase pulse is substantially equal to the predetermined phase magnitude.

By selecting the predetermined amplitude of the phase pulse to be equal to the predetermined phase magnitude, this embodiment becomes simple to realise.

In a second embodiment of the digital PLL according to the invention the digital PLL is characterized, in that for the case where at least two phase pulses occur in a time interval, the pulse duration increases for each next phase pulse in that time interval.

In that case the output signal of the digital oscillator becomes highly integrable, so that it will be sufficient for the PLL to comprise a low-pass filter with a very small time constant.

In a third embodiment of the digital PLL according to the invention the digital PLL is characterized, in that the digital oscillator further includes control means for generating a control signal whose duration corresponds to the time interval, these control means having an output coupled to a control input of the conveying means for conveying the control signal to the shifting-cum-multiplex means, a first phase shift occurring in response to a first control signal and a next phase shift occurring in response to a next control signal.

By permitting each phase shift to occur in response to a control signal whose duration corresponds to the time interval, the magnitude of the frequency change of the reference signal can be adjusted by adjusting the duration of the control signal by way of the control means, whereas the magnitude of the phase shifts remaining constant. If the duration of the control signal and thus the length of the time interval decreases, there will be more phase shifts per second and the frequency change will increase. If the duration of the control signal and thus the length of the time interval increases, there will be fewer phase shifts per second and the frequency change will decrease.

In a fourth embodiment of the digital PLL according to the invention the digital PLL is characterized, in that the control means are arranged for temporarily generating the next control signal during the first control signal, the duration of the first control signal corresponding to the time interval and the duration of the next control signal corresponding to the pulse duration of the phase pulse.

Since in this PLL the next phase shift already temporarily occurs in the digital oscillator during the time interval situated between the first phase shift and the next phase shift, the output signal of the digital oscillator is better integrable as has already been described hereinbefore. The pulse duration of the phase pulse is then adjustable by varying the length of the next temporarily generated control signal.

In a fifth embodiment of the digital PLL according to the invention the digital PLL is characterized, in that the control means comprise dividing means for dividing the time interval belonging to the first control signal into sub-intervals, for permitting the control means to temporarily generate the next control signal during these sub-intervals, the control signal duration increasing for each next sub-interval and having a maximum length equal to that of the sub-interval.

The output signal of the oscillator used in this PLL is highly integrable as has already been described hereinbefore. If the dividing means divide the time interval into, for example, 4 sub-intervals, while in the first interval the next phase shift does not occur, in the second sub-interval the next phase shift occurs during 1/4 of this sub-interval, in the third sub-interval the next phase shift occurs during 2/4 of this sub-interval and in the fourth sub-interval the next phase shift occurs during 3/4 of this sub-interval, it will be sufficient for the PLL to comprise a low-pass filter having a very small time constant when an oscillator of this type is used, even if a very small minimum frequency change of, for example, 1/64 Hz is possible.

In a sixth embodiment of the digital PLL according to the invention, the digital PLL is characterized, in that the shifting-cum-multiplexing means comprise a shift register and a multiplexer, an input of the shift register forming the input to the digital oscillator and outputs of the shift register being coupled to inputs of the multiplexer, and an output of the multiplexer forming the output of the digital oscillator.

This PLL has a very simple structure. If, for example, phase shifts of 90° each are desired, the shift register is to have 4 outputs at which the reference signal is available phase shifted by 0°, 90°, 180° and 270° respectively. Each output is coupled to a corresponding input of the multiplexer which each time couples one of its inputs to its output. At this output the reference signal phase shifted per time interval is then available.

In an seventh embodiment of the digital PLL according to the invention the digital PLL is characterized, in that the control means comprise a first counter, a second counter and a comparator, least significant outputs of which first counter being coupled to a first input of the comparator, outputs of which second counter being coupled to a second input of the comparator, most significant outputs of which first counter together with a comparator output forming the output of the control means, this control means output being coupled to a control input of the multiplexer, the control input forming the control input of the shifting-cum-multiplexing means and the first counter forming the dividing means.

The most significant outputs of the first counter generate the control signal in response to which the frequency shift occurs per time interval. The duration of this signal, which duration corresponds to the time interval, is thus determined by the cycle time of the least significant outputs. The number of possible counts present on the least significant outputs then correspond to the number of sub-intervals per time interval. The comparator decides whether this count is greater than the count present on the second counter for temporarily generating during the sub-intervals the next control signals of durations which increase for each sub-interval.

The invention will be further explained with reference to an exemplary embodiment shown in the drawing Figures, in which:

Fig. 1 shows the digital PLL according to the invention,
Fig. 2 shows a time diagram of the signals available in the digital oscillator, and
Fig. 3 gives a survey of reference signal phase shifts for different pulse generator frequencies.

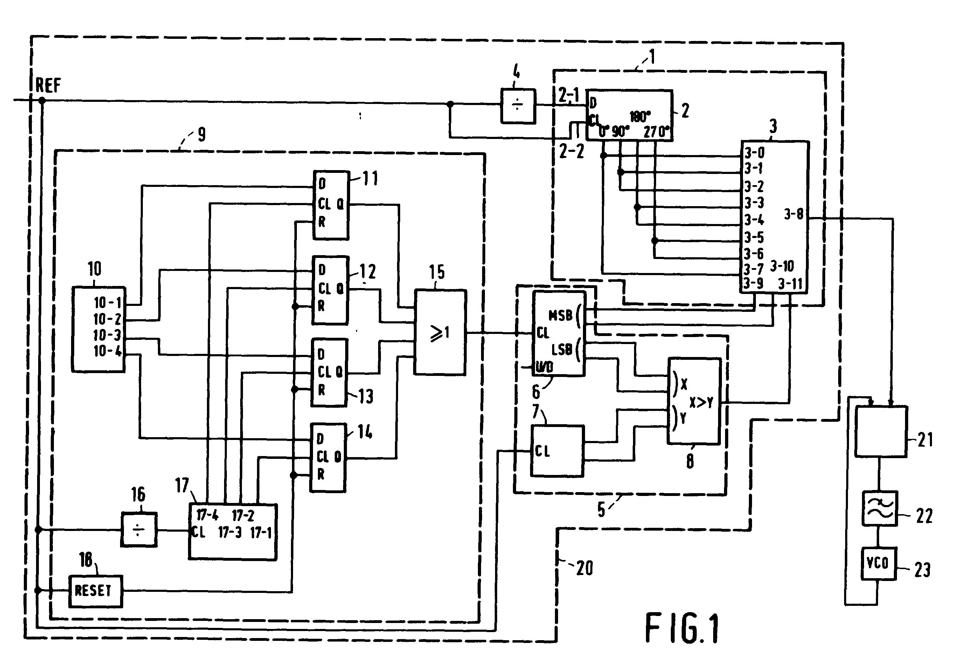

The digital PLL shown in Fig. 1 comprises a digital oscillator 20, a phase detector 21, a low-pass filter 22 and a Voltage Controlled Oscillator 23 (VCO). An output of VCO 23 is connected to a first input of phase detector 21 of which a output is connected to an input of VCO 23 *via* low-pass filter 22. An output of oscillator 20 is connected to a second input of phase detector 21. The oscillator 20 comprises shifting-cum-multiplexing means 1 which include a shift register 2 and a multiplexer 3. A data input 2-1 of shift register 2 forms a input of the shifting-cum-multiplexing means 1 and receives through divider 4 a reference signal which is further applied directly to a clock input 2-2 of the shift register 2. This reference signal comes, for example, from a crystal (not shown) oscillating at a frequency of 8 MHz. When the divider 4 divides by a factor of four, data input 2-1 is supplied with a signal having a frequency of 2 MHz. The shift register 2 has four outputs at which the signal applied to the data input 2-1 is available phase shifted each time by 90°. A 0° output is connected to inputs 3-0 and 3-7 of the multiplexer 3, a 90° output is connected to the inputs 3-1 and 3-2, a 180° output is connected to the inputs 3-3 and 3-4 and a 270° output is connected to inputs 3-5 and 3-6. Output 3-8 of the multiplexer 3 forms a output of the shifting-cum-multiplexing means 1 at which a output signal is available. Furthermore, multiplexer 3 has three control inputs 3-9, 3-10 and 3-11 which together form one control input of shifting-cum-multiplexing means 1. The coupling of the outputs of the shift register 2 to the inputs of the multiplexer 3 is such that control signals sent to control inputs 3-9 and 3-10 decide which output of the shift register 2 is coupled to the output of the shifting-cum-multiplexing means 1. By way of the control signal to control input 3-11 a next output of the shift register may then be (temporarily) coupled through. In principle, by way of control signals to the control inputs 3-9 and 3-10, there is determined which of the inputs 3-0, 3-2, 3-4 or 3-6 is connected to the output 3-8 and by way of a control signal to control input 3-11, there is determined whether the input 3-1 is to be connected *in lieu of* input 3-0, or the input 3-3 *in lieu of* input 3-2, or the input 3-5 *in lieu of* input 3-4, or the input 3-7 *in lieu of* input 3-6. This actually means that the 90° phase jump is realised per time interval by the control signals sent to the control input 3-9 and 3-10, whereas the temporary additional 90° phase jump (phase pulse in this case with a 90° amplitude) is realised during the time interval by way of a control signal to control input 3-11.

These control signals are generated by control means 5 comprising a first counter 6, a second counter 7 and a comparator 8. Counter 6 has four outputs. The most significant outputs are coupled to control input 3-9 and 3-10 of the multiplexer 3 while the two least significant outputs are coupled to a first input of the comparator 8. Counter 7 has two outputs which are coupled to a second input of comparator 8. The output of comparator 8 is coupled to control input 3-11. A clock input of counter 7 receives the reference signal and a clock input of counter 6 is coupled to a output of a programmable pulse generator 9.

This programmable pulse generator 9 comprises a buffer 10 having four outputs for adjusting and storing a specific data word available at the outputs. The first, least significant output 10-1 of the buffer is coupled to a data input of a D-flipflop (DFF) 11, the second output 10-2 is coupled to a data input of DFF 12, the third output 10-3 is coupled to a data input of DFF 13 and a fourth, most significant output 10-4 is coupled to a data input of DFF 14. Outputs of the DFFs 11, 12, 13 and 14 are coupled to the inputs of OR gate 15, an output of OR gate 15 forming an output of the control means and being coupled to a clock input of the counter 6. Pulse generator 9 further includes a divider 16 and a counter 17. The first, least significant output 17-1 of this counter is coupled to a clock input of DFF 14, the second output 17-2 is coupled to a clock input of DFF 13, the third output 17-3 is coupled to a clock input of DFF 12 and the fourth, most significant output 17-4 of counter 17 is coupled to a clock input of DFF 11. Reset inputs of the DFFs 11, 12, 13 and 14 are coupled to a reset circuit 18 which, as does divider 16, receives the reference signal. An output of divider 16 is coupled to a clock input of counter 17.

The operation of the digital oscillator 20, which comprises the shifting-cum-multiplexing means 1, the control means 5 and the programmable pulse generator 9 is as follows. The pulse generator 9 generates a signal with an adjustable frequency, for example, 1 MHz. This signal is applied to the clock input of counter 6, in response to which this counter 6 counts with a frequency of 1 MHz and increments its count by unity every microsecond. The cycle time of the two least significant outputs of counter 6 is then four microseconds, which implies that the count of the two most significant outputs of counter 6 is incremented by unity every four microseconds. In response to this, the multiplexer 3 couples a next output of the shift register 2 every four microseconds, a 90° phase shift being realised in the output signal every four microseconds. Every sixteen microseconds the phase shift is then 360°, which corresponds to a frequency change of 62.5 kHz. For a signal having a frequency of 2 MHz and applied to data input 2-1, an output signal of 1.9375 MHz will appear at output 3-8.

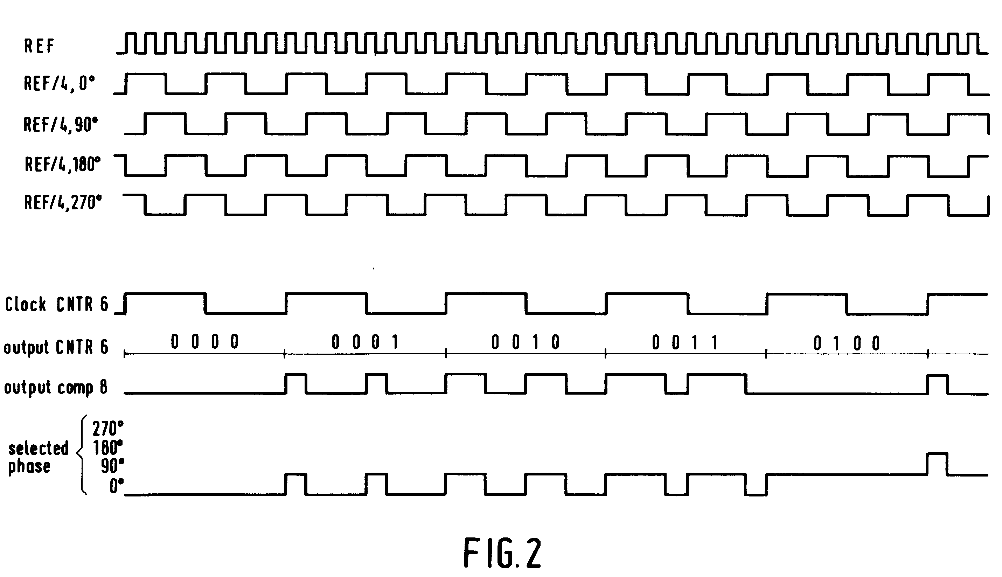

The time diagram shown in Fig. 2 illustrates the operation of the oscillator 20 at signal level. It is again assumed that the frequency of the reference signal is 8 MHz and that the pulse generator 9 generates a signal with a frequency of 1 MHz, which signal is applied to the clock input of counter 6. Counter 6 thus counts with a frequency of 1 MHz from 0(0000) to 15(1111) and increments its count by unity every microsecond. Counter 7 counts with a frequency of 8 MHz from 0(00) to 3 (11) and increments its count by unity every 1/8 microsecond.

The count of counter 6 is 0000 during a first microsecond. Both most significant outputs as well as both least significant outputs have the logic value "zero". Comparator 8 compares to find whether the count on both least significant outputs is greater than the count of counter 7 which counts two complete cycles during this first microsecond. Since the value 00 is never greater than the count of counter 7, comparator 8 generates a signal having the logic value "zero" for this first microsecond. The three control inputs 3-9, 3-10 and 3-11 of multiplexer 3 receive control signals having the logic value "zero", in response to which input 3-0 is coupled to output 3-8 for this first microsecond. The output signal is then the reference signal divided by four and not phase-shifted (or phase-shifted by 0°).

The count of counter 6 is 0001 during a second microsecond. Comparator 8 compares the count (01) on both least significant outputs with the count of counter 7. If this count is 00, the count on both least significant outputs is greater and comparator 8 will generate a signal having the logic value "one". During this second microsecond, comparator 8 will thus generate a signal of the logic value "one" twice, each time for 1/8 microsecond (the duration of each count on counter 7). Control input 3-11 is supplied with this signal in response to which input 3-1 instead of input 3-0 is coupled to output 3-8 twice during this second microsecond, each time for 1/8 microsecond, while the output signal is then the reference signal phase-shifted by 90° and divided by four, *in lieu of* the reference signal (divided by four) which is not phase-shifted.

The count of counter 6 is 0010 during a third microsecond. The count (10) on both least significant outputs is greater than the counts 00 and 01 of counter 7 and during this third microsecond comparator 8 will thus generate a signal of a logic value "one" twice, each time for 2/8 microsecond. Control input 3-11 is supplied with this signal in response to which input 3-1 *in lieu of* input 3-0 is coupled to output 3-8 twice during this third microsecond, each time for 2/8 microsecond, while the output signal is then the reference signal phase-shifted by 90° and divided by four *in lieu of* the reference signal (divided by four) which is not phase-shifted.

The count of counter 6 is 0011 during a fourth microsecond. The count (11) on both least significant outputs is greater than the counts 00, 01 and 10 of counter 7, and during this fourth microsecond comparator 8 will thus generate a signal having a logic value "one" twice, each time for 3/8 microsecond. Control input 3-11 is supplied with this signal in response to which input 3-1 *in lieu of* input 3-0 is coupled to output 3-8 twice during this fourth microsecond, each time for 3/8 microsecond, while the output signal is then the reference signal phase-shifted by 90° and divided by four, *in lieu of* the reference signal (divided by four) which is not phase-shifted.

The count of counter 6 is 0100 during a fifth microsecond. The count on both most significant outputs (01) is applied to the control inputs 3-9 and 3-10 in response to which input 3-2 is coupled to output 3-8. During this fifth microsecond the output signal is then constantly the reference signal phase-shifted by 90° and divided by four, because the count on both least significant outputs (00) is never greater than the count of counter 7, and comparator 8 thus constantly generates during this fifth microsecond a signal having a logic value "zero".

During a sixth microsecond comparator 8 again generates a signal having a logic value "one" twice, each time with a duration of 1/8 microsecond. Clock input 3-11 is supplied with this signal in response to which input 3-3 *in lieu of* input 3-2 is coupled to the output 3-8 twice during this sixth microsecond, each time for 1/8 microsecond, the output signal then being the reference signal phase-shifted by 180° and divided by four *in lieu of* the reference signal phase-shifted by 90° (divided by four), and so on.

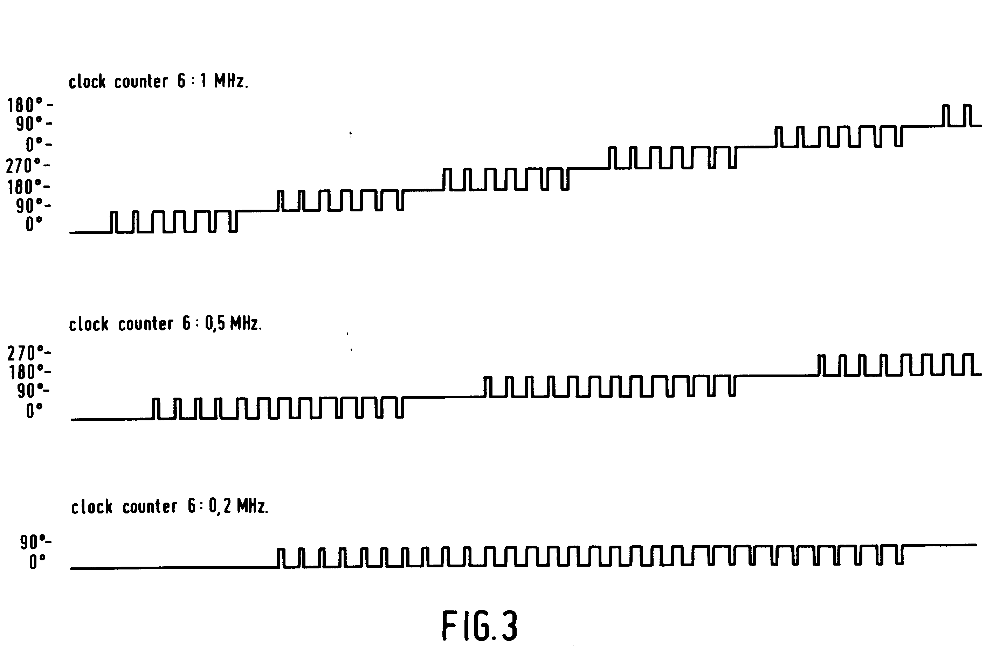

Fig. 3 shows the aforementioned over a larger time interval for signals generated by the programmable pulse generator 9 with a frequency of 1 MHz, 0.5 MHz and 0.2 MHz. In the first case the output frequency is 1.9375 MHz as has already been calculated hereinbefore. For the second and third cases the output frequency may be similarly calculated to be 1.96875 MHz and 1.9875 MHz respectively.

With the aid of the programmable pulse generator 9 represented in Fig. 1 an adjustable frequency pulse signal is generated. This frequency is adjusted by means of the data word stored in buffer 10. If this data word is, for example, 0001, only DFF 11 out of the DFFs 11, 12, 13 and 14 receives at its data input a signal having the logic value "one". For example, if the dividend of divider 16 is, for example, four, counter 17 is supplied with a clock signal having a frequency of 2 MHz and will then increment its count by unity every 0.5 microsecond. The fourth, most significant output 17-4 of counter 17, connected to the clock input of DFF 11, then alternately has the values "zero" and "one" for 4 microseconds. During a complete 8-microsecond-long cycle period of counter 17, DFF 11, which is of the edge-triggered type, receives in this case one clock pulse in 8 microseconds. Because the data input of DFF 11 is supplied with a signal having the logic value "one", DFF 11 will generate one output pulse in 8 microseconds in response to the clock pulse, which output pulse also appears at the output of pulse generator 9 through OR gate 15. Pulse generator 9 thus generates an output signal having a frequency of 1/8 MHz.

If the data word in buffer 10 is 0010, the data input of DFF 12 is supplied with a signal having the logic value "one". The third output 17-3 of counter 17, which is connected to the clock input of DFF 12, has the value "zero" for 2 microseconds and the value "one" for the next two microseconds. DFF 12 is then supplied with two clock pulses in 8 microseconds and generates two output pulses in 8 microseconds. Pulse generator 9 then generates an output signal having a frequency of 2/8 = 1/4 MHz.

If the data word in buffer 10 is, for example, 0011, the data inputs of both DFF 11 and DFF 12 are supplied with signals having the logic value "one". Because DFF 11 is supplied with one and DFF 12 with two pulses in 8 microseconds, and these pulses do not coincide, the pulse generator 9 will generate three output pulses in 8 microseconds. The frequency of this output signal is then 3/8 MHz, and so on.

In the case of a data word 1111 in buffer 10, the data inputs of all the DFFs 11, 12, 13 and 14 are supplied with the logic value "one" and their clock inputs with 15 non-coinciding pulses in 8 microseconds coming from the counter 17. Pulse generator 9 will then generate 15 output pulses in 8 microseconds which corresponds to an output signal having a frequency of 15/8 MHz.

In this manner a signal can be generated with the pulse generator 9 with a frequency which is adjustable in steps between 1/8 MHz and 15/8 MHz. This signal is applied to counter 6 and causes, as has already been described, a frequency change to occur in the output signal of the digital oscillator 20. Thus, the output frequency of the digital oscillator 20 may be adjusted by a choice of a specific data word from buffer 10.

If, it generally holds that:

$F_{PPG}$     is the frequency of the output signal of the programmable pulse generator 9,
$F_{REF}$     is the frequency of the reference signal,
$D_1$     is the dividend of the divider 16,
$N$     is the number of outputs of counter 17 and
$K$     is the value of data word in buffer 10, for $F_{PPG}$ there may be simply found that:

$$F_{PPG} = \frac{F_{REF} \times K}{2^N \times D_1}$$

The minimum desired frequency step $F_{STEPMIN}$ in the output signal of the programmable pulse generator 9 affects the magnitude of N. Generally, the following is to hold for N:

$$\frac{F_{REF}}{2^N \times D_1} \leq F_{STEPMIN} < \frac{F_{REF}}{2^{N-1} \times D_1}$$

The maximum desired frequency $F_{PPGMAX}$ of the output signal of the programmable pulse generator 9 affects the magnitude of $D_1$. Generally, the following is to hold for $D_1$:

$$\frac{F_{REF}}{D_1+1} < F_{PPGMAX} \leq \frac{F_{REF}}{D_1}$$

If it generally holds that:

$F_{OUT}$     is the output frequency of the digital oscillator 20,
$D_2$     is the dividend of the divider 4,
$P$     is the number of outputs of the counter 7 and
$P+2$     is the number of outputs of the counter 6, there may simply be found for $F_{OUT}$ that:

$$F_{OUT} = \frac{F_{REF}}{D_2} - \frac{F_{PPG}}{2^{P+2}}$$

If the digital oscillator 20 is used in the PLL, the time constant of the low-pass filter 22 is to be greater than

$$\frac{1}{F_{STEPMIN} \times 2^{2(P+2)}}$$

and greater than

$$\frac{2^P}{F_{REF}}$$

The optimum value for P (the number of outputs of counter 7) may be calculated from this in a simple manner:

$$P = \frac{\log \sqrt{F_{REF}} - \log \sqrt{4 \times F_{STEPMIN} \times 2^{P+2}}}{\log 2}$$

With this optimum value for P the jitter frequency $F_{JITTER}$ is:
Herein $F_{STEPMIN} \times 2^{P+2}$ is the minimum step size of the output frequency $F_{OUT}$ of the

$$F_{JITTER} = 2 \times \sqrt{F_{REF} \times F_{STEPMIN} \times 2^{P+2}}$$

digital oscillator 20. Since this jitter frequency $F_{JITTER}$ is extremely high, even for a small value for $F_{STEPMIN}$, it will generally be sufficient for this PLL to include a simple and fast low-pass filter 22.

In this manner it is possible to generate an output frequency $F_{OUT}$ by means of the digital oscillator 20, for which frequency holds: $F_{OUT} < F_{REF}/D_2$. By permitting counter 6 to have an Up/Down input, due to which the counter 6 is enabled to decrement its count by a value "one" in addition to incrementing its count by the value "one", it is possible to permit the oscillator 20 also to generate an output frequency $F_{OUT}$ for which holds: $F_{OUT} > F_{REF}/D_2$ For example, if a processor produces the data word for buffer 10, depending on specific measurement results, this processor may also trigger the Up/Down input of counter 6.

## Claims

1. Digital Phase Locked Loop, comprising a Voltage Controlled Oscillator (23) and a phase detector (21) whose output is coupled to an input of the Voltage Controlled Oscillator (23) *via* a low-pass filter (22), an output of the Voltage Controlled Oscillator (23) being coupled to a first input of the phase detector (21) whose second input is coupled to an output of a digital oscillator (20), the digital oscillator (20) comprising shifting-cum-multiplexing means (1) for shifting by a predetermined phase magnitude per time interval a reference signal presented to an input of the digital oscillator, and for generating an output signal at the output of the digital oscillator (20) which output signal is the reference signal shifted by a predetermined phase magnitude per time interval, characterized in that the shifting-cum-multiplexing means (1) of the digital oscillator (20) are arranged for additionally phase-shifting the reference signal in the time interval by means of at least one phase pulse introducing a positive phase shift and a negative phase shift with a predetermined amplitude, said phase pulse being situated in the time interval.

2. Digital Phase Locked Loop as claimed in Claim 1, characterized in that the predetermined amplitude is substantially equal to the predetermined phase magnitude.

3. Digital Phase Locked Loop as claimed in Claim 2, characterized in that for the case where at least two phase pulses occur in a time interval, the pulse duration increases for each next phase pulse in that time interval.

4. Digital Phase Locked Loop as claimed in Claim 3, characterized in that the digital oscillator (20) further includes control means (5) for generating a control signal whose duration corresponds to the time interval, these control means (5) having an output coupled to a control input of the conveying means for conveying the control signal to the shifting-cum-multiplex means (1), a first phase shift occurring in response to a first control signal and a next phase shift occurring in response to a next control signal.

5. Digital Phase Locked Loop as claimed in Claim 4, characterized in that the control means (5) are arranged for temporarily generating the next control signal during the first control signal, the duration of the first control signal corresponding to the time interval and the duration of the next control signal corresponding to the pulse duration of the phase pulse.

6. Digital Phase Locked Loop as claimed in Claim 5, characterized in that the control means (5) comprise dividing means (6) for dividing the time interval belonging to the first control signal into sub-intervals, for permitting the control means (5) to temporarily generate the next control signal during these sub-intervals, the control signal duration increasing for each next sub-interval and having a maximum length equal to that of the sub-interval.

7. Digital Phase Locked Loop as claimed in Claim 6, characterized in that the shifting-cum-multiplexing means (1) comprise a shift register (2) and a multiplexer (3), an input of the shift register (2) forming the input to the digital oscillator (20) and outputs of the shift register (2) being coupled to inputs of the multiplexer (3), and an output of the multiplexer (3) forming the output of the digital oscillator.

8. Digital Phase Locked Loop as claimed in Claim 7, characterized in that the control means (5) comprise a first counter (6), a second counter ((7) and a comparator (8), least significant outputs of which first counter (6) being coupled to a first input of the comparator (8), outputs of which second counter (7) being coupled to a second input of the comparator (8), most significant outputs of which first counter (6) together with a comparator output forming the output of the control means (5), this control means output being coupled to a control input of the multiplexer (3), the control input forming the control input of the shifting-cum-multiplexing means (1) and the first counter (6) forming the dividing means.

9. Digital oscillator (20) comprising shifting-cum-multiplexing means (1) for shifting by a predetermined phase magnitude per time interval a reference signal presented to an input of the digital oscillator (20), and for generating an output signal at the output of the digital oscillator (20) which output signal is the reference signal shifted by a predetermined phase magnitude per time interval, characterized in that the shifting-cum-multiplexing means (1) of the digital oscillator (20) are arranged for additionally phase-shifting the reference signal in the time interval by means of at least one phase pulse introducing a positive phase shift and a negative phase shift with a predetermined amplitude, said phase pulse being situated in the time interval.

**Patentansprüche**

1. Digitale Phasenverriegelungsschleife mit einem spannungsgesteuerten Oszillator (23) und einem Phasendetektor (21), dessen Ausgang über ein Tiefpaßfilter (22) mit einem Eingang des spannungsgesteuerten Oszillators (23) gekoppelt ist, von dem ein Ausgang mit einem ersten Eingang des Phasendetektors (21) gekoppelt ist, von dem ein zweiter Eingang mit einem Ausgang eines digitalen Oszillators (20) gekoppelt ist, wobei der digitale Oszillator (20) Schiebe-und-Multiplexmittel (1) enthält zum um eine vorbestimmte Phasengröße je Zeitintervall Verschieben eines an einem Eingang des digitalen Oszillators vorhandenen Bezugssignals und zum Erzeugen eines Ausgangssignals an dem Ausgang des digitalen Oszillators (20), wobei dieses Ausgangssignal das um eine vorbestimmte Phasengröße je Zeitintervall verschobene Bezugssignal ist, dadurch gekennzeichnet, daß die Schiebe-und-Multiplexmittel (1) des digitalen Oszillators (20) vorgesehen sind zum mittels wenigstens eines in dem Zeitintervall liegenden Phasenimpulses mit einer vorbestimmten Amplitude in dem Zeitintervall zusätzlichen Phasenschieben des Bezugssignals.

2. Digitale Phasenverriegelungsschleife nach Anspruch 1, dadurch gekennzeichnet, daß die vorbestimmte Amplitude der vorbestimmten Phasengröße nahezu entspricht.

3. Digitale Phasenverriegelungsschleife nach Anspruch 2, dadurch gekennzeichnet, daß für den Fall, daß wenigstens zwei Phasenimpulse in einem Zeitintervall auftreten, für jeden nächsten Phasenimpuls in diesem Zeitintervall die Impulsdauer zunimmt.

4. Digitale Phasenverriegelungsschleife nach Anspruch 3, dadurch gekennzeichnet, daß der digitale Oszillator (20) weiterhin Steuermittel (5) aufweist zum Erzeugen eines Steuersignals, dessen Dauer dem Zeitintervall entspricht, wobei von diesen Steuermitteln (5) ein Ausgang mit einem Steuereingang der Beförderungsmittel gekoppelt ist zum Befördern des Steuersignals zu den Schiebe-und-Multiplexmitteln (1), wobei eine erste Phasenverschiebung in Antwort auf ein erstes Steuersignal auftritt und wobei eine nächste Phasenverschiebung in Antwort auf ein nächstes Steuersignal auftritt.

5. Digitale Phasenverriegelungsschleife nach Anspruch 4, dadurch gekennzeichnet, daß die Steuermittel (5) dazu eingerichtet sind, während des ersten Steuersignals, dessen Dauer dem Zeitintervall entspricht, vorübergehend das nächste Steuersignal erzeugen, dessen Dauer der Impulsdauer des Phasenimpulses entspricht.

6. Digitale Phasenverriegelungsschleife nach Anspruch 5, dadurch gekennzeichnet, daß die Steuermittel (5) mit Aufteilungsmitteln (6) versehen sind zum Aufteilen des dem ersten Steuersignal zugeordneten Zeitintervalls in Teilintervalle, damit die Steuermittel (5) während dieser Teilintervalle vorübergehend das nächste Steuersignal erzeugen, dessen Dauer bei jedem nachfolgenden Teilintervall zunimmt und der Länge des Teilintervalls höchstens entspricht.

7. Digitale Phasenverriegelungsschleife nach Anspruch 6, dadurch gekennzeichnet, daß die Schiebe-und-Multiplexmittel (1) ein Schieberegister (2) und einen Multiplexer (3) aufweisen, wobei ein Eingang des Schieberegisters (2) den Eingang des digitalen Oszillators (20) bildet und wobei Ausgänge des Schieberegisters (2) mit Eingängen des Multiplexers (3) gekoppelt sind und ein Ausgang des Multiplexers (3) den Ausgang des digitalen Oszillators bildet.

8. Digitale Phasenverriegelungsschleife nach Anspruch 7, dadurch gekennzeichnet, daß die Steuermittel (5) einen ersten Zähler(6), einen zweiten Zähler (7) und eine Vergleichsstufe (8) aufweisen, wobei die am wenigsten signifikanten Ausgänge des ersten Zählers (6) mit einem ersten Eingang der Vergleichsstufe (8) gekoppelt sind, wobei Ausgänge des zweiten Zählers (7) mit einem zweiten Eingang der Vergleichsstufe (8) gekoppelt sind, wobei die signifikantesten Ausgänge des ersten Zählers (6) zusammen mit einem Ausgang der Vergleichsstufe den Ausgang der Steuermittel (5) bilden, wobei dieser Ausgang der Steuermittel mit einem Steuereingang des Multiplexers (3) gekoppelt ist, wobei dieser Steuereingang den Steuereingang der Schiebe- und Multiplexmittel (1) bildet, und wobei der erste Zähler (6) die Aufteilungsmittel bildet.

9. Digitaler Oszillator (20) mit Schiebe-und-Multiplexmitteln (1) zum um eine vorbestimmte Phasengröße je Zeitintervall Phasenschieben eines Bezugssignals, das an einem Eingang des digitalen Oszillators (20) vorhanden ist, und zum Erzeugen eines Ausgangssignals an dem Ausgang des digitalen Oszillators (20) wobei dieses Ausgangssignal das um eine vorbestimmte Phasengröße je Zeitintervall verschobene Bezugssignal ist, dadurch gekennzeichnet, daß die Schiebe-und-Multiplexmittel (1) des digitalen Oszillators (20) zum zuätzlichen Phasenschieben des Bezugssignals in dem Zeitintervall mittels wenigstens eines Phsenimpulses, der eine positive Phasenverschiebung und eine negative Phasenverschiebung mit einer vorbestimmten Amplitude herbeiführt, wobei der genannte Phasenimpuls in dem Zeitintevall liegt.

## Revendications

1. Boucle numérique à verrouillage de phase comprenant un oscillateur commandé en tension (23) et un détecteur de phase (21) dont la sortie est connectée à une entrée de l'oscillateur commandé en tension (23) par l'intermédiaire d'un filtre passe-bas (22), une sortie de l'oscillateur commandé en tension (23) étant connectée à une première entrée du détecteur de phase (21) dont la seconde entrée est connectée à une sortie d'un oscillateur numérique (20), l'oscillateur numérique (20) comprenant des moyens de décalage avec multiplexage (1) pour décaler d'une grandeur de phase prédéterminée par intervalle de temps, un signal de référence présenté à une entrée de l'oscillateur numérique et pour générer à la sortie de l'oscillateur numérique (20), un signal de sortie qui est le signal de référence décalé d'une grandeur de phase prédéterminée par intervalle de temps, caractérisé en ce que les moyens de décalage avec multiplexage (1) de l'oscillateur numérique (20) sont conçus pour provoquer un décalage de phase supplémentaire du signal de référence dans l'intervalle de temps à l'aide d'au moins une impulsion de phase introduisant un décalage de phase positif et un décalage de phase négatif d'une amplitude prédéterminée ladite impulsion de phase étant située dans l'intervalle de temps.

2. Boucle numérique à verrouillage de phase suivant la revendication 1, caractérisée en ce que l'amplitude prédéterminée de l'impulsion de phase est en substance égale à la grandeur de phase prédéterminée.

3. Boucle numérique à verrouillage de phase suivant la revendication 2, caractérisée en ce que dans le cas où au moins deux impulsions de phase se présentent dans un intervalle de temps, la durée d'impulsion augmente pour chaque impulsion de phase suivante dans cet intervalle de temps.

4. Boucle numérique à verrouillage de phase suivant la revendication 3, caractérisée en ce que l'oscillateur numérique (20) comprend en outre des moyens de commandes (5) pour générer un signal de commande dont la durée correspond à l'intervalle de temps, ces moyens de commande (5) présentant une sortie connectée à une entrée de commande des moyens de transport pour transporter le signal de commande vers les moyens de décalage avec multiplexage (1), un premier décalage de phase ayant lieu en réaction à un premier signal de commande et un décalage de phase suivant ayant lieu en réaction à un signal de commande suivant.

5. Boucle numérique à verrouillage de phase suivant la revendication 4, caractérisée en ce que les moyens de commande (5) sont agencés de manière à générer temporairement le signal de commande suivant pendant le premier signal de commande, la durée du premier signal de commande correspondant à l'intervalle de temps et la durée du signal de commande suivant correspondant à la durée d'impulsion de l'impulsion de phase.

6. Boucle numérique à verrouillage de phase suivant la revendication 5, caractérisée en ce que les moyens de commande (5) comprennent des moyens de division (6) pour diviser l'intervalle de temps appartenant au premier signal de commande en sous-intervalles pour permettre aux moyens de commande (5) de générer temporairement le signal de commande suivant pendant ces sous-intervalles, la durée du signal de commande augmentant pour chaque sous-intervalle suivant et présentant une longueur maximale égale à celle du sous-intervalle.

7. Boucle numérique à verrouillage de phase suivant la revendication 6, caractérisée en ce que les moyens de décalage avec multiplexage (1) comprennent un registre à décalage (2) et un multiplexeur (3), une entrée du registre à décalage (2) formant l'entrée de l'oscillateur numérique (20) et des sorties du registre à décalage (2) étant connectées à des entrées du multiplexeur (3), une sortie du multiplexeur (3) formant la sortie de l'oscillateur numérique.

8. Boucle numérique à verrouillage de phase suivant la revendication 7, caractérisée en ce que les moyens de commande (5) comprennent un premier compteur (6), un second compteur (7) et un comparateur (8), les sorties les moins significatives du premier compteur (6) étant appliquées à une première entrée du comparateur (8), les sorties du second compteur (7) étant appliquées à une seconde entrée du comparateur (8), les sorties les plus significatives du premier compteur formant avec une sortie du comparateur la sortie des moyens de commande (5), cette sortie des moyens de commande étant appliquée à une entrée de commande du multiplexeur (3), l'entrée de commande formant l'entrée de commande des moyens de décalage avec multiplexage (1) et le premier compteur (6) formant les moyens de division.

9. Oscillateur numérique (20) comprenant des moyens de décalage avec multiplexage (1) pour décaler d'une grandeur de phase prédéterminée par intervalle de temps un signal de référence présenté à une entrée de l'oscillateur numérique (20) et pour générer un signal de sortie à la sortie de l'oscillateur numérique (20), ce signal de sortie étant le signal de référence décalé d'une grandeur de phase prédéterminée par intervalle de temps, caractérisé en ce que les moyens de décalage avec multiplexage (1) de l'oscillateur numérique (20) sont conçus pour provoquer un décalage de phase supplémentaire du signal de référence dans l'intervalle de temps à l'aide d'au moins une impulsion de phase introduisant un décalage de phase positif et un décalage de phase négatif d'une grandeur prédéterminée, ladite impulsion de phase étant située dans l'intervalle temps.

FIG.1

FIG.2

EP 0 512 621 B1

clock counter 6 : 1 MHz.

180° -
90° -
0° -
270° -
180° -
90° -
0°

clock counter 6 : 0,5 MHz.

270° -
180° -
90° -
0°

clock counter 6 : 0,2 MHz.

90° -
0°

# FIG.3